# EUROPEAN PATENT APPLICATION

(11) **EP 4 749 314 A1**
(43) Date of publication of application: **27.05.2026**
(21) Application number: 24215406.0
(22) Date of filing: 26.11.2024
(51) Int. Cl.: G01R 33/422

(54) **MAGNETIC RESONANCE SYSTEM INCLUDING EXPANDED RADIO FREQUENCY (RF) SCREEN**

(71) Applicant: Koninklijke Philips N.V., 5656 AE Eindhoven (NL)
(72) Inventor: FORTHMANN, Peter, Eindhoven (NL); OOME, Martin Cornelius, Eindhoven (NL)
(74) Representative: Philips Intellectual Property & Standards

(57) **Abstract**

A magnetic resonance (MR) system acquires MR imaging data from a subject. The MR system includes a main magnet unit (105) configured to generate a magnetic field in a bore (115) for receiving the subject. The main magnet unit includes a cryostat (110) and superconducting coils (130) in the cryostat, where an outer hull (111) of the cryostat includes at least one composite layer (112a, 112b) and at least one metal layer (113) for ensuring a vacuum seal within the cryostat; an external radio frequency (RF) screen (140, 340) coupled to the main magnet unit, where the external RF screen is configured to block transmission of RF signals into and/or out of the main magnet unit; and at least one joint (145, 245, 345, 445) electrically connecting the at least one metal layer in the outer hull of the cryostat to the external RF screen to provide an expanded RF screen (170, 370).

## Description

### FIELD OF THE INVENTION

The invention relates to the field of magnetic resonance (MR) imaging, and more specifically to providing radio frequency (RF) screens for superconducting magnets in cryostats formed of composite material.

### BACKGROUND

Superconducting magnets may be used in MR imaging systems that require strong magnetic fields, such as MR imaging (MRI) and nuclear MR (NMR) imaging systems, for example. A superconducting magnet includes one or more electrically conductive magnet coils formed by superconducting wire. To realize superconductivity, the magnet is maintained in a cryogenic environment at a temperature near absolute zero during operation, enabling the superconducting magnet to operate at or below a cryogenic temperature, e.g., 4 Kelvin (K). The cryogenic environment is provided by a cryostat containing liquid helium (LHe) in a vacuum. In the superconducting state, the magnet coils are referred to as superconducting coils, which effectively have no electrical resistance and therefore conduct much larger electric currents to create the strong magnetic fields for performing MR imaging. Operation of a superconducting magnet in the superconducting state may be referred to as persistent current mode. The persistent current mode is the state in which an electrical circuit (e.g., including the superconducting coils) carries electrical current substantially indefinitely and without the need for an external power source due to the absence of electrical resistance.

Generally, MR imaging systems operate in a space (e.g., a scanning room) that is clean from external radio frequency (RF) signals, so that only RF signals from the subject are picked up. Likewise, it is expected that MR imaging systems will not pollute the area with the RF signals that it generates. To prevent transmission of RF signals into and/or out of an MR imaging system, the interior of the scanning room containing the MR imaging system may be lined with a thin metallic layer. However, shrouding the entire scanning room with RF screen material is a significant effort, and the smaller the operating area or space to be covered, the better. Also, a signal damping waveguide may be incorporated that runs through the magnet bore of the main magnet unit of the MR imaging system. Typically, an outer metallic vessel of the main magnet unit is used as part of the wave guide. However, if superconducting magnets are made from composite materials, it is no longer possible to use the vessel of the main magnet unit as a waveguide since the composite materials are not electrically conductive.

In addition, an MR imaging system may be combined with a linear accelerator to combine radiation therapy of a subject with MR imaging. The radiation therapy typically includes use of therapeutic beams aimed directly at a cancerous growth of the subject, protecting heathy tissue from high doses of radiation. In this case, the therapeutic beam traverses the cryostat of the superconducting magnet in order to reach the subject. A conventional cryostat formed of a metal material absorbs a portion the radiation therapy, thereby reducing the efficacy of the radiation treatment.

### SUMMARY

According to a representative embodiment, a magnetic resonance (MR) system is provided for acquiring MR imaging data from a subject. The MR system includes a main magnet unit configured to generate a magnetic field in a bore defined by the main magnet unit for receiving the subject, where the main magnet unit includes a cryostat and superconducting coils housed in the cryostat, where an outer hull of the cryostat includes at least one composite layer formed of a composite material and at least one metal layer formed of a first metal material for ensuring a vacuum seal within the cryostat; an external radio frequency (RF) screen coupled to the main magnet unit, where the external RF screen is configured to block transmission of RF signals into and/or out of the main magnet unit; and at least one j oint configured to electrically connect the at least one metal layer in the outer hull of the cryostat to the external RF screen to provide an expanded RF screen.

According to another representative embodiment, an MR system is provided for acquiring MR imaging data from a subject. The MR system includes a main magnet unit configured to generate a magnetic field in a bore defined by the main magnet unit for receiving the subject, where the main magnet unit includes a cryostat and superconducting coils housed in the cryostat, where an outer hull of the cryostat includes at least one composite layer formed of a composite material and a metal layer for ensuring a vacuum seal within the cryostat; a metallic room screen arranged on at least a portion of walls and/or at least a portion of a ceiling of a scanning room housing the main magnet unit to provide an RF shield; and a joint configured to electrically connect the metal layer in the outer hull of the cryostat to the metallic room screen to provide an expanded RF screen configured to block transmission of RF signals into and/or out of the main magnet unit.

According to another representative embodiment, an MR system is provided for acquiring MR imaging data from a subject. The MR system includes a main magnet unit configured to generate a magnetic field in a bore defined by the main magnet unit for receiving the subject, where the main magnet unit includes a cryostat and superconducting coils housed in the cryostat, where an outer hull of the cryostat includes at least one composite layer formed of a composite material and a metal layer formed for ensuring a vacuum seal within the cryostat; a metallic waveguide extension positioned adjacent to at least one end of the bore for extending an RF waveguide defined by the bore; and a j oint configured to electrically connect the metal layer in the outer hull of the cryostat to the metallic waveguide extension to provide an expanded RF screen configured to block transmission of RF signals into and/or out of the main magnet unit.

### BRIEF DESCRIPTION OF THE DRAWINGS

The example embodiments are best understood from the following detailed description when read with the accompanying drawing figures. It is emphasized that the various features are not necessarily drawn to scale. In fact, the dimensions may be arbitrarily increased or decreased for clarity of discussion. Wherever applicable and practical, like reference numerals refer to like elements.
FIG. 1 is a simplified cross-sectional diagram of an MR system with an expanded RF screen including a room screen, according to a representative embodiment.
FIG. 2 is a simplified cross-sectional diagram of an MR system with an expanded RF screen including a room screen, according to a representative embodiment.
FIG. 3 is a simplified cross-sectional diagram of an MR system with an expanded RF screen including a waveguide extension, according to a representative embodiment.
FIG. 4 is a simplified cross-sectional diagram of an MR system with an expanded RF screen including a waveguide extension, according to a representative embodiment.

### DETAILED DESCRIPTION

In the following detailed description, for purposes of explanation and not limitation, representative embodiments disclosing specific details are set forth in order to provide a thorough understanding of an embodiment according to the present teachings. Descriptions of known systems, devices, materials, methods of operation and methods of manufacture may be omitted so as to avoid obscuring the description of the representative embodiments. Nonetheless, systems, devices, materials and methods that are within the purview of one of ordinary skill in the art are within the scope of the present teachings and may be used in accordance with the representative embodiments. It is to be understood that the terminology used herein is for purposes of describing particular embodiments only, and is not intended to be limiting. The defined terms are in addition to the technical and scientific meanings of the defined terms as commonly understood and accepted in the technical field of the present teachings. Features described in relation to a system, may be implemented in a method in a corresponding manner.

It will be understood that, although the terms first, second, third etc. may be used herein to describe various elements or components, these elements or components should not be limited by these terms. These terms are only used to distinguish one element or component from another element or component. Thus, a first element or component discussed below could be termed a second element or component without departing from the teachings of the inventive concept.

The terminology used herein is for purposes of describing particular embodiments only, and is not intended to be limiting. As used in the specification and appended claims, the singular forms of terms "a," "an" and "the" are intended to include both singular and plural forms, unless the context clearly dictates otherwise. Additionally, the terms "comprises," and/or "comprising," and/or similar terms when used in this specification, specify the presence of stated features, elements, and/or components, but do not preclude the presence or addition of one or more other features, elements, components, and/or groups thereof. As used herein, the term "and/or" includes any and all combinations of one or more of the associated listed items.

Unless otherwise noted, when an element or component is said to be "connected to," "coupled to," or "adjacent to" another element or component, it will be understood that the element or component can be directly connected or coupled to the other element or component, or intervening elements or components may be present. That is, these and similar terms encompass cases where one or more intermediate elements or components may be employed to connect two elements or components. However, when an element or component is said to be "directly connected" to another element or component, this encompasses only cases where the two elements or components are connected to each other without any intermediate or intervening elements or components.

In view of the foregoing, the present disclosure, through one or more of its various aspects, embodiments and/or specific features or sub-components, is thus intended to bring out one or more of the advantages as specifically noted below. For purposes of explanation and not limitation, example embodiments disclosing specific details are set forth in order to provide a thorough understanding of an embodiment according to the present teachings. However, other embodiments consistent with the present disclosure that depart from specific details disclosed herein remain within the scope of the appended claims. Moreover, descriptions of well-known apparatuses and methods may be omitted so as to not obscure the description of the example embodiments. Such methods and apparatuses are within the scope of the present disclosure.

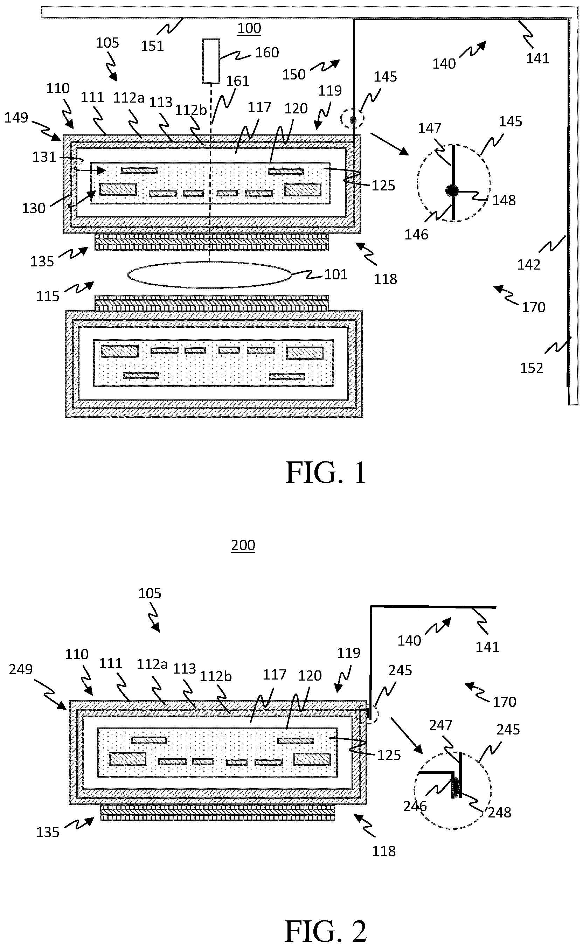

FIG. 1 is a simplified cross-sectional diagram of an MR system with an expanded RF screen including a room screen, according to a representative embodiment.

Referring to FIG. 1, MR system 100 is configured to acquire MR imaging data from a subject 101. The MR system 100 may be any type of imaging system using superconducting magnets for imaging subjects, such as an MR imaging (MRI) system or a nuclear MR (NMR) imaging system, for example. The MR system 100 includes a main magnet unit 105, which is a superconducting magnet, configured to generate a magnetic field in a bore 115, which is a horizontal, axial cavity defined by the main magnet unit 105 communicating with atmospheric air for receiving the subject 101 positioned on a table for the MR imaging process. An imaging zone is provided in the bore 115 where the magnetic field generated by operation of the superconducting magnet is strong and uniform enough to perform the magnetic resonance imaging.

The MR system 100 further includes gradient coils 135, arranged to at least partially surround at least a portion of the subject 101, configured to enable spatial encoding of the magnetic field. The gradient coils 135 create a secondary magnetic field that varies linearly along x, y, and z axes, respectively, to create three-dimensional images of the subject 101. In addition, the MR system 100 includes RF coil (not shown) configured to apply an RF signal to at least a portion of the patient 101 being imaged to alter alignment of the magnetic field, and a scanner (not shown) configured to detect changes in the magnetic field caused by the RF signal. The RF coil is configured to manipulate orientations of magnetic spins within the imaging zone, and to receive RF transmissions from spins also within the imaging zone. The RF coil is connected to an RF transceiver, which transmits and receives RF signals to and from the RF coil during the MR imaging procedure. In general, operation of an MR system is well known and therefore will not be repeated herein.

The main magnet unit 105 includes superconducting coils 130 and a generally circularly symmetrical cryostat 110 that provides cryogenic temperatures to the superconducting coils 130. The superconducting coils 130 are magnet windings of superconducting material, such as niobium-titanium, germanium-niobium, or yttrium barium copper oxide (YBCO), for example, for the superconducting magnet. The main magnet unit 105 may further include shield coils 131, which are also magnet windings of superconducting material located in the cryostat 110 The shield coils 131 are configured to provide active main static magnetic field (B₀) shielding of the patient 101 in the bore 115. The cryostat 110 is substantially toroid-shaped, where an outer hull 111 of the cryostat 110 defines an outer roll-up 119 around an outer circumference of the toroid and an inner roll-up 118 around in inner circumference corresponding to the hole through the toroid, which defines an outer diameter of the bore 115. The cryostat 110 may include a first portion (first stage of a cold head) operating at an intermediate temperature (e.g., 40 K) and a second portion (second stage of the cold head) operating at cryogenic temperature (e.g., 4 K).

The outer hull 111 of the cryostat 110 defines a vacuum chamber 117 for providing a vacuum within the cryostat 110. Within the vacuum chamber 117, the main magnet unit 105 further includes one or more heat shields (not shown), a cryogenic chamber 120 within the one or more heat shields, and the superconducting coils 130 within the cryogenic chamber 120. The cryogenic chamber 120 contains coolant, such as liquid helium (LHe), for example, for cooling the superconducting coils 130 to the cryogenic temperature, so that they operate in a superconducting state. Other types of gas and/or liquid coolant may be incorporated without departing from the scope of the present teachings. Means for supplying the coolant to the cryogenic chamber 120 and applying vacuum to the vacuum chamber 117 would be apparent to one skilled in the art, and therefore additional descriptions are not provided herein.

Electrical conductive leads are provided for connecting with and energizing the superconducting coils 130. A static electric current flowing through the superconducting coils 130 generates a constant B₀ magnetic field, which is oriented horizontally at the bore 115. After ramping the electric current in the superconducting coils 130 to a level that provides the desired B₀ magnetic field strength, the conductive leads may be withdrawn and the zero electrical resistance of the superconducting coils 130 ensures that electric current will continue to flow in a persistent manner. The coolant in the cryogenic chamber 120 is maintained to prevent the superconducting coils 130 from warming above the superconducting critical temperature.

The outer hull 111 of the cryostat 110 is formed of one or more composite layers, indicated by representative composite layers 112a and 112b. The composite layers 112a and 112b may be formed of any compatible composite material, such as glass fiber, reinforced plastic (GFRP), or carbon fiber, for example. Use of composite material has a number of advantages over conventional cryostats formed of metal. For example, the weight of composite material is significantly less. Also, in the depicted embodiment, the MR system 100 optionally includes a linear accelerator 160 configured to generate and emit x-ray radiation in a therapeutic beam 161 toward the subject 101, thereby combining external beam radiation therapy with MR imaging, as mentioned above. Combining the linear accelerator 160 with the MR system 100 enables real-time control of the therapeutic beam 161 during treatment, providing the ability to adapt the radiation delivery as needed at each treatment. Alternatively, the linear accelerator 160 may generate and emit other types of radiation, such proton radiation, for example. As shown, the therapeutic beam 161 traverses the cryostat 110 to reach the subject 101. However, use of composite material in the composite layers 112a and 112b of the outer hull 111 substantially reduces or prevents absorption of the therapeutic beam 161 by the cryostat 110 in comparison with conventional cryostats formed of metal.

Composite materials are generally less suitable to form vessels for creating and maintaining a vacuum than metal materials. For example, composite materials are more porous on a micro-level as compared to metals, which may result in vacuum problems. This is especially the case when vessel walls are thin, which could be the case in order to reduce weight and cost of the cryostat 110. Therefore, one or more thin metal layers, indicated by representative metal layer 113, may be included in the outer hull 111 as a vacuum seal to make the cryostat 110 vacuum tight. The metal layer 113 may be formed of any compatible metal material, such as aluminum or copper, for example. The metal layer 113 is thick enough to assure that the cryostat 110 is vacuum tight, but thin enough to avoid significant absorption of the therapeutic beam 161. For example, the thickness of the metal layer 113 may be in a range of about 5.0 µm to about 50 µm. The metal layer 113 may be arranged anywhere on or within the composite material in the outer hull 111 without departing from the scope of present teachings. For example, in the depicted embodiment, the metal layer 113 is arranged within the composite material, between the adjacent composite layers 112a and 112b. In alternative embodiments, the metal layer 113 may be arranged on an inner-most surface of the outer hull 111 (i.e., an inner surface of the composite layer 112b) or on an outer-most surface of the outer hull 111 (i.e., an outer surface of the composite layer 112a).

The MR system 100 is located in a scanning room 150, which includes ceiling 151 and representative wall 152 for purposes of illustration. A controller (not shown) for setting up and operating the MR system 100 may be located in a control room physically separate from the scanning room 150. The controller may be any combination of one or more processing devices, such as a microprocessor, a microcontroller, a field programmable gate array (FPGA), an erasable programmable logic device (EPLD) and/or an application-specific integrated circuit (ASIC), for example, executing instructions, e.g., stored in memory and/or on a computer readable medium, as would be apparent to one of ordinary skill in the art. A user interface may be provided to enable a user to interact with the controller.

As mentioned above, the main magnet unit 105 is sensitive to RF radiation, so the scanning room 150 must be clean from external RF signals generated from outside the scanning room 150 and internal RF signals generated by the MR system 100 itself (e.g., by the RF coils). Accordingly, a room screen is applied inside the scanning room 150 as an external RF screen 140 (external to the main magnet unit 105) for shielding at least a portion of the scanning room 150 from RF radiation. The external RF screen 140 includes ceiling RF screen 141 on a portion of the ceiling 151 and wall RF screen 142 on a portion of the wall 152 of the scanning room 150. The ceiling and wall RF screens 141 and 142 each may be formed of a thin metallic layer (e.g., foil), such as aluminum or copper, for example, having a thickness in a range of about 0.1 mm to about 0.2 mm.

In the depicted embodiment, in order to reduce the size of external RF screen 140 applied to the ceiling and wall(s) of the scanning room 150, an internal RF screen 149 (internal to the main magnet unit 105) may be joined with the external RF screen 140 to provide a combined or expanded RF screen 170. The internal RF screen 149 must be formed of metal to shield against RF signals. Therefore, the internal RF screen 149 includes the metal layer 113 that forms the vacuum seal in the outer hull 111 of the cryostat 110, and does not include the composite layers 112a and 112b.

A joint 145 is configured to electrically connect the metal layer 113 of the internal RF screen 149 to the external RF screen 140 to create the expanded RF screen 170. In particular, the joint 145 (shown magnified in a dashed circle) electrically connects the metal layer 113 to the ceiling RF screen 141 at the outer roll-up 119 of the outer hull 111 to extend the external RF screen 140. The joint 145 includes a first bridge (flange) 146, a second bridge 147, and a mechanical connection 148. The first and second bridges 146 and 147 may be formed of the same or different electrically conductive material as the metal layer 113. The first and second bridges 146 and 147 are significantly thicker than the metal layer 113 so that they can be handled, as a practical matter. The first bridge 146 extends (e.g., radially upward) from a horizontal end portion (e.g., upper right corner) of the metal layer 113 through the composite layer 112a at the outer roll-up 119 of the outer hull 111. The second bridge 147 extends (e.g., radially downward) from the ceiling RF screen 141 on the ceiling 151. The mechanical connection 148 connects distal ends of the first bridge 146 and the second bridge 147 to one another. The mechanical connection 148 may be any compatible connection that securely fastens the first and second bridges 146 and 147, such as a solder joint, a clamp, a spot weld, an ultrasound weld, a crimped connection, or a screw connection, for example, assuring electrical communication between the metal layer 113 and the ceiling RF screen 141. When the mechanical connection 148 is solder and the metal layer 113 is aluminum, the ends of the metal layer 113 may need to be treated to accept the solder and/or to avoid corrosion. The RF screening is thus extended from the external RF screen 140 across the width of the cryostat 110 by means of the internal RF screen 149, together with the first bridge 146 and the second bridge 147. This dual use of the metal layer 113 in the outer hull 111 saves cost and time by not having to install external RF screening in the scanning room 150 around those portions of the main magnet unit 105 that are otherwise shielded by the internal RF screen 149.

FIG. 2 is a simplified cross-sectional diagram of an MR system with an expanded RF screen including a room screen, according to a representative embodiment, where the external RF screen is connected to the internal RF screen by a different joint than the joint 145 shown in FIG. 1.

Referring to FIG. 2, MR system 200 is substantially the same as MR system 100 in FIG. 1, although only a top half of the main magnet unit 105 is shown for the sake of convenience. Also, only the ceiling RF screen 141 formed on the portion of the ceiling 151 is shown since it is the part of the external RF screen 140 that directly connects to the internal RF screen 249. As discussed above, the main magnet unit 105 includes the cryostat 110, which has the outer hull 111 defining the vacuum chamber 117. The outer hull 111 is formed of the composite layers 112a and 112b and the metal layer 113, which provides the vacuum seal for the cryostat 110.

In the depicted embodiment, the internal RF screen 249 included in the main magnet unit 105 is joined with the external RF screen 140 by a joint 245 to provide the expanded RF screen 170. In particular, the joint 245 (shown magnified in a dashed circle) electrically connects the metal layer 113 to the ceiling RF screen 141 applied to the ceiling 151 of the scanning room 150 at the outer roll-up 119 of the outer hull 111. The joint 245 includes an L-shaped tab 246 extending axially from a horizontal end portion (upper right corner) of the metal layer 113 at the outer roll-up 119. A first leg of the L-shaped tab 246 extends through the composite layer 112a and a second leg of the L-shaped tab 246 extends (e.g., perpendicular) to the first leg along an exterior surface (end flange) of the outer hull 111, creating an exposed edge or contact area. Notably, the L-shaped tab 246 presents the L-shape only in cross-sectional views, as shown, with the second leg bent along the end flange. It is understood, however, that in three-dimensions, the L-shape is rotationally symmetric around a longitudinal axis through the bore 115 in the cryostat 110, thereby creating an exposed circumferential edge or contact area around the end flange of the outer hull 111. The L-shaped tab 246 is significantly thicker than the metal layer 113 so that it can be handled, as a practical matter.

The joint 245 further includes a bridge 247 that extends (e.g., radially downward) from the ceiling RF screen 141, and a mechanical connection 248 that connects the second leg of the L-shaped tab 246 to a distal end portion of the bridge 247. The distal end portion of the bridge 247 may also include an exposed contact area, which is configured to electrically connect to the edge or contact area on the L-shaped tab 246. The mechanical connection 248 may be any compatible connection that securely fastens the second leg of the L-shaped tab 246 and the bridge 247 to one another, such as a solder joint, a clamp, a spot weld, an ultrasound weld, a crimped connection, or a screw connection, for example, assuring electrical communication between the metal layer 113 and the ceiling RF screen 141. The RF screening is thus extended from the external RF screen 140 across the width of the cryostat 110 by means of the internal RF screen 149, together with the L-shaped tab 246 and the bridge 247.

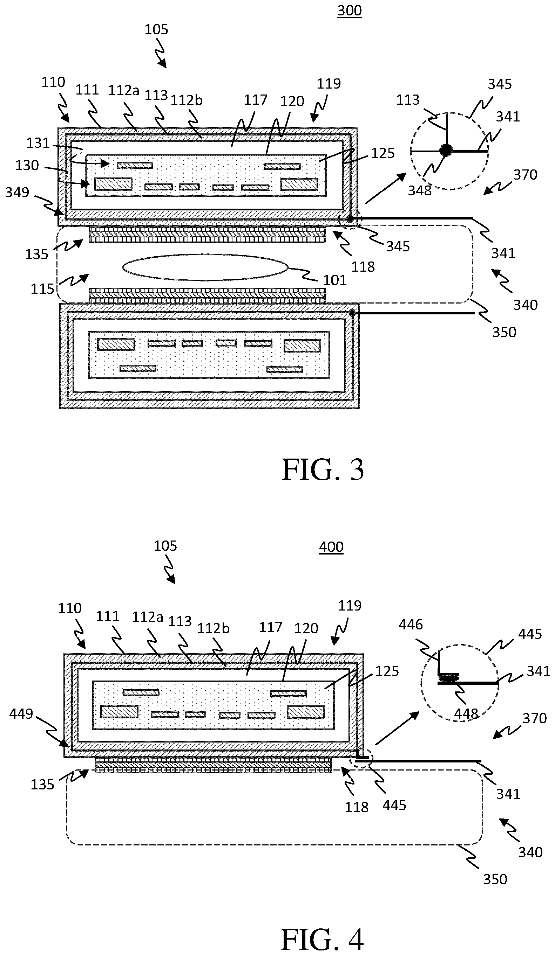

As mentioned above, other types of RF screening of MR systems include signal damping waveguides that run through the magnet bore of the main magnet unit. FIG. 3 is a simplified cross-sectional diagram of an MR system with an expanded RF screen including a waveguide extension, according to a representative embodiment.

Referring to FIG. 3, MR system 300 is substantially the same as the MR system 100 in FIG. 1, without the external RF screen 140 and the linear accelerator 160. However, it is understood that one or both of the external RF screen 140 and the linear accelerator 160 may be included with the internal RF screening and waveguide extension of the MR system 300, discussed below, without departing from the scope of the present teachings.

The MR system 300 includes the main magnet unit 105 configured to generate a magnetic field in the bore 115 holding the subject 101. The main magnet unit 105 includes the cryostat 110, which includes the outer hull 111 defining the vacuum chamber 117. The vacuum chamber 117 contains the cryogenic chamber 120, which contains the superconducting coils 130 of the superconducting magnet. The outer hull 111 is formed of the composite layers 112a and 112b and the metal layer 113, which provides the vacuum seal for the cryostat 110.

As discussed above, the inner roll-up 118 of the outer hull 111 defines the outer diameter of the bore 115. The metal layer 113 in the outer hull 111 causes the bore 115 to act as a waveguide 350 for RF signals, such that internally generated RF signals (e.g., from the RF coil), as well as externally generated RF signals, are directed away from the main magnet unit 105. That is, with regard to wave propagation through a hollow conductor, there are known relationships between the radius and length of the hollow conductor and the wavelength of the wave. In general, the smaller the radius or the longer the hollow conductor, the higher the damping of longer wavelengths. Accordingly, an internal RF screen 349 includes the metal layer 113. The MR system 300 further includes an external waveguide extension as an external RF screen 340. The external RF screen 340 extends the waveguide created by the metal layer 113 in the bore 115 outside of the main magnet unit 105, thereby providing additional screening of RF signals. The external RF screen 340 is formed by a waveguide RF screen 341 (waveguide extension), which may be formed of a thin metallic layer, such as aluminum or copper, for example, having a thickness in a range of about 0.1 mm to about 1.0 mm. The waveguide RF screen 341 may be free standing, as shown, or may be applied to a non-metallic casing for additional structural support. Also, although only one external RF screen 340 is shown, it is understood that an additional waveguide extension connected to the metal layer 113 on the opposite side of the bore 115 in the same manner as described below may be included without departing from the scope of the present teachings.

A joint 345 is configured to electrically connect the metal layer 113 of the internal RF screen 349 to the external RF screen 340 to create a combined or expanded RF screen 370. In particular, the joint 345 (shown magnified in a dashed circle) electrically connects the metal layer 113 to the waveguide RF screen 341 at the inner roll-up 118 or a flange (not shown) of the outer hull 111 to extend the internal RF screen 349 outwardly, making it longer. The joint 345 thus includes the corner of the metal layer 113, the waveguide RF screen 341, and a mechanical connection 348, which connects the metal layer 113 and a proximal end of the waveguide RF screen 341 to one another. The mechanical connection 348 may be any compatible connection that securely fastens the metal layer 113 and the waveguide RF screen 341, such as a solder joint, a clamp, a spot weld, an ultrasound weld, a crimped connection, or a screw connection, for example, assuring electrical communication between the same. The RF screening is thus extended from the internal RF screen 349 across the width of the external RF screen 340, thereby extending the length of the waveguide 350 as well. Notably, although the external RF screen 340 is shown extending only from the right side of the bore 115, it is understood that another external RF screen (not shown) connected to the metal layer 113 may extend from the left side of the bore 115 in addition to the external RF screen 340 in a symmetrical configuration, or the other external RF screen may extend from the left side of the bore 115 with no external RF screen 340 extending from the right side, without departing from the scope of the present teachings. This dual use of the metal layer 113 in the outer hull 111 saves costs and time by not having to install external RF screening in the scanning room.

In an alternative embodiment, the joint 345 may be shifted outside the outer hull 111 by a bridge or flange (not shown) that extends axially to the right from a horizontal end portion (lower right corner) of the metal layer 113 through the composite layer 112a at the inner roll-up 118 of the outer hull 111. In this case, the mechanical connection 348 between the bridge and the waveguide RF screen 341 would be located outside the outer hull 111.

FIG. 4 is a simplified cross-sectional diagram of an MR system with an expanded RF screen including a waveguide extension, according to a representative embodiment, where the external RF screen is connected to the internal RF screen by a different joint than the joint 345 shown in FIG. 3.

Referring to FIG. 4, MR system 400 is substantially the same as MR system 300 in FIG. 3, although only a top half of the main magnet unit 105 is shown for the sake of convenience. As discussed above, the main magnet unit 105 includes the cryostat 110, which has the outer hull 111 defining the vacuum chamber 117. The outer hull 111 is formed of the composite layers 112a and 112b and the metal layer 113, which provides the vacuum seal for the cryostat 110.

In the depicted embodiment, the internal RF screen 449 included in the main magnet unit 105 is joined with the external RF screen 340 by a joint 445 to provide the expanded RF screen 370. In particular, the joint 445 (shown magnified in a dashed circle) electrically connects the metal layer 113 to the waveguide RF screen 341 at the inner roll-up 118 or a flange (not shown) of the outer hull 111. The joint 445 includes an L-shaped tab 446 extending (e.g., radially) from a horizontal end portion (bottom right corner) of the metal layer 113 at the inner roll-up 118.A first leg of the L-shaped tab 446 extends through the composite layer 112a and a second leg of the L-shaped tab 446 extends (e.g., perpendicular) to the first leg along an exterior surface of the outer hull 111, creating an exposed edge or contact area. As discussed above with respect to the L-shaped tab 446, the L-shaped tab 446 presents the L-shape only in cross-sectional views, as shown, with the second leg bent along the end flange. It is understood, however, that in three-dimensions, the L-shape is rotationally symmetric around the longitudinal axis through the bore 115 in the cryostat 110, thereby creating an exposed circumferential edge or contact area around the end flange of the outer hull 111. Also, the L-shaped tab 446 is significantly thicker than the metal layer 113 so that it can be handled, as a practical matter.

The joint 445 further includes the waveguide RF screen 341, and a mechanical connection 448 that connects the second leg of the L-shaped tab 446 to a proximal end portion of the waveguide RF screen 341. The proximal end portion of the waveguide RF screen 341 may also include an exposed contact area, which is configured to electrically connect to the edge or contact on the L-shaped tab 446. The mechanical connection 448 may be any compatible connection that securely fastens the second leg of the L-shaped tab 446 and the waveguide RF screen 341 to one another, such as a solder joint, a clamp, a spot weld, an ultrasound weld, a crimped connection, or a screw connection, for example, assuring electrical communication between the metal layer 113 and the waveguide RF screen 341. The RF screening is thus extended from the internal RF screen 449 across the width of the external RF screen 340, together with the L-shaped tab 446, thereby extending the length of the waveguide 350 as well.

It is understood that one or more of the aforementioned embodiments of the invention may be combined as long as the combined embodiments are not mutually exclusive. The term expanded in the context of the invention is to be interpreted as enlarged or extended. Although embodiments of the MR system with an expanded RF screen for shielding a main magnet from RF signals has been described with reference to several exemplary embodiments, it is understood that the words that have been used are words of description and illustration, rather than words of limitation. Changes may be made within the purview of the appended claims, as presently stated and as amended, without departing from the scope and spirit of the system in its aspects. Although the MR system for with the expanded RF screen has been described with reference to particular means, materials and embodiments, the MR system is not intended to be limited to the particulars disclosed; rather the MR system extends to all functionally equivalent structures, methods, and uses such as are within the scope of the appended claims.

Although the present specification describes components and functions that may be implemented in particular embodiments with reference to particular standards and protocols, the disclosure is not limited to such standards and protocols. Such standards are periodically superseded by more efficient equivalents having essentially the same functions. Accordingly, replacement standards and protocols having the same or similar functions are considered equivalents thereof.

The illustrations of the embodiments described herein are intended to provide a general understanding of the structure of the various embodiments. The illustrations are not intended to serve as a complete description of all of the elements and features of the disclosure described herein. Many other embodiments may be apparent to those of skill in the art upon reviewing the disclosure. Other embodiments may be utilized and derived from the disclosure, such that structural and logical substitutions and changes may be made without departing from the scope of the disclosure. Additionally, the illustrations are merely representational and may not be drawn to scale. Certain proportions within the illustrations may be exaggerated, while other proportions may be minimized. Accordingly, the disclosure and the figures are to be regarded as illustrative rather than restrictive.

One or more embodiments of the disclosure may be referred to herein, individually and/or collectively, by the term "invention" merely for convenience and without intending to voluntarily limit the scope of this application to any particular invention or inventive concept. Moreover, although specific embodiments have been illustrated and described herein, it should be appreciated that any subsequent arrangement designed to achieve the same or similar purpose may be substituted for the specific embodiments shown. This disclosure is intended to cover any and all subsequent adaptations or variations of various embodiments. Combinations of the above embodiments, and other embodiments not specifically described herein, will be apparent to those of skill in the art upon reviewing the description.

The Abstract of the Disclosure is provided to comply with 37 C.F.R. §1.72(b) and is submitted with the understanding that it will not be used to interpret or limit the scope or meaning of the claims. In addition, in the foregoing Detailed Description, various features may be grouped together or described in a single embodiment for the purpose of streamlining the disclosure. This disclosure is not to be interpreted as reflecting an intention that the claimed embodiments require more features than are expressly recited in each claim. Rather, as the following claims reflect, inventive subject matter may be directed to less than all of the features of any of the disclosed embodiments. Thus, the following claims are incorporated into the Detailed Description, with each claim standing on its own as defining separately claimed subject matter.

The preceding description of the disclosed embodiments is provided to enable any person skilled in the art to practice the concepts described in the present disclosure. As such, the above disclosed subject matter is to be considered illustrative, and not restrictive, and the appended claims are intended to cover all such modifications, enhancements, and other embodiments which fall within the true spirit and scope of the present disclosure. Thus, to the maximum extent allowed by law, the scope of the present disclosure is to be determined by the broadest permissible interpretation of the following claims and their equivalents, and shall not be restricted or limited by the foregoing detailed description.

## Claims

1. A magnetic resonance, MR, system for acquiring MR imaging data from a subject, the MR system comprising:
a main magnet unit (105) configured to generate a magnetic field in a bore (115) defined by the main magnet unit for receiving the subject, wherein the main magnet unit comprises a cryostat (110) and superconducting coils (130) housed in the cryostat, wherein an outer hull (111) of the cryostat comprises at least one composite layer (112a, 112b) formed of a composite material and at least one metal layer (113) formed of a first metal material for ensuring a vacuum seal within the cryostat;
an external radio frequency, RF, screen (140, 340) coupled to the main magnet unit, wherein the external RF screen is configured to block transmission of RF signals into and/or out of the main magnet unit; and
at least one joint (145, 245, 345, 445) configured to electrically connect the at least one metal layer in the outer hull of the cryostat to the external RF screen to provide an expanded RF screen (170, 370).

2. The MR system of claim 1, wherein the external RF screen is a room screen formed of a second metal material and covering at least a portion of walls and/or at least a portion of a ceiling of a scanning room housing the main magnet unit, and
wherein the at least one joint electrically connects the room screen and the at least one metal layer at an outer roll-up of the outer hull of the cryostat to form the expanded RF screen for blocking transmission of RF signals into and/or out of the main magnet unit through the walls and/or the ceiling of the scanning room.

3. The MR system of claim 2, wherein the at least one j oint comprises a first bridge extending from an end portion of the at least one metal layer at the outer roll-up of the outer hull, a second bridge extending from the room screen, and a mechanical connection for connecting the first and second bridges.

4. The MR system of claim 2, wherein the at least one joint comprises an L-shaped tab comprising a first leg extending from an end portion of the at least one metal layer at the outer roll-up of the outer hull and a second leg extending perpendicular to the first leg along an exterior surface of the outer hull, a bridge extending from the room screen, and a mechanical connection for connecting the bridge to the second leg of the L-shaped tab.

5. The MR system of claim 4, wherein the at least one joint further comprises a first contact area accessible at an end portion of the at least one metal layer at the outer roll-up of the outer hull, and wherein the first contact area is configured to electrically connect to a second contact area at an end portion of the room screen.

6. The MR system of any one of claims 1 to 5, further comprising:
a linear accelerator configured to generate radiation directed to the subject in the bore of the main magnet unit while acquiring the MR imaging data, wherein the radiation passes through a portion of the at least one composite layer.

7. The MR system of claim 1, wherein the external RF screen is a waveguide extension formed of a second metal material and positioned adjacent to at least one end of the bore for extending an RF waveguide defined by the bore, and
wherein the at least one joint electrically connects the waveguide extension and the at least one metal layer at an inner roll-up of the outer hull of the cryostat to form the expanded RF screen for blocking transmission of RF signals into and/or out of the main magnet unit through the RF waveguide.

8. The MR system of claim 7, wherein the at least one joint comprises either
an end portion of the at least one metal layer at the inner roll-up of the outer hull, a waveguide RF screen of the waveguide extension, and a mechanical connection configured to connect the end portion of the at least one metal layer to a proximal end portion of the waveguide RF screen; or
an L-shaped tab comprising a first leg extending from an end portion of the at least one metal layer at the inner roll-up of the outer hull and a second leg extending perpendicular to the first leg along an exterior surface of the outer hull, a waveguide RF screen of the waveguide extension, and a mechanical connection configured to connect the second leg of the L-shaped tab to the waveguide RF screen.

9. The MR system of claim 8, wherein the at least one joint further comprises a first contact area accessible at an end portion of the at least one metal layer at the inner roll-up of the outer hull, wherein the first contact area is configured to electrically connect to a second contact area at an end portion of the waveguide extension.

10. A magnetic resonance, MR, system for acquiring MR imaging data from a subject, the MR system comprising:
a main magnet unit (105) configured to generate a magnetic field in a bore (115) defined by the main magnet unit for receiving the subject, wherein the main magnet unit comprises a cryostat (110) and superconducting coils (130) housed in the cryostat, wherein an outer hull (111) of the cryostat comprises at least one composite layer (112a, 112b) formed of a composite material and a metal layer (113) for ensuring a vacuum seal within the cryostat;
a metallic room screen (140) arranged on at least a portion of walls and/or at least a portion of a ceiling of a scanning room housing the main magnet unit to provide a radio frequency, RF, shield; and
a joint (145, 245) configured to electrically connect the metal layer in the outer hull of the cryostat to the metallic room screen to provide an expanded RF screen (170) configured to block transmission of RF signals into and/or out of the main magnet unit.

11. The MR system of claim 10, wherein the joint comprises either
a first bridge extending radially from a horizontal end portion of the metal layer; a second bridge extending radially from the portion of the ceiling of the scanning room; and a mechanical connection configured to connect distal ends of the first bridge and the second bridge; or
an L-shaped tab comprising a first leg extending axially from a horizontal end portion of the metal layer and a second leg extending perpendicular to the first leg along an exterior surface of the outer hull; a bridge extending radially from the portion of the ceiling of the scanning room; and a mechanical connection configured to connect the second leg of the L-shaped tab and a distal end portion of the bridge.

12. A magnetic resonance, MR, system for acquiring MR imaging data from a subject, the MR system comprising:
a main magnet unit (105) configured to generate a magnetic field in a bore (115) defined by the main magnet unit for receiving the subject, wherein the main magnet unit comprises a cryostat (110) and superconducting coils (130) housed in the cryostat, wherein an outer hull (111) of the cryostat comprises at least one composite layer (112a, 112b) formed of a composite material and a metal layer (113) formed for ensuring a vacuum seal within the cryostat;
a metallic waveguide extension (340) positioned adjacent to at least one end of the bore for extending a radio frequency, RF, waveguide (350) defined by the bore; and
a joint (345, 445) configured to electrically connect the metal layer in the outer hull of the cryostat to the metallic waveguide extension to provide an expanded RF screen (370) configured to block transmission of RF signals into and/or out of the main magnet unit.

13. The MR system of claim 12, wherein the joint comprises either
a corner of the metal layer; a waveguide RF screen of the metallic waveguide extension; and a mechanical connection configured to connect the corner of the metal layer to a proximal end portion of the waveguide RF screen; or
an L-shaped tab comprising a first leg extending radially from a horizontal end portion of the metal layer and a second leg extending perpendicular to the first leg along an exterior surface of the outer hull; a waveguide RF screen of the metallic waveguide extension; and a mechanical connection configured to connect the second leg of the L-shaped tab to a proximal end portion of the waveguide RF screen.

14. The MR system of any one of the preceding claims, wherein the at least one metal layer is at least one of the following:
formed on an inner-most surface of the at least one composite layer;
formed on an outer-most surface of the at least one composite layer; and
formed between two adjacent composite layers of the at least one composite layer.

15. The MR system of any one of the preceding claims, wherein the composite material comprises glass fiber, reinforced plastic, GFRP, or carbon fiber, and wherein the first metal material comprises aluminum or copper.
